Europäisches Patentamt

**(19)** European Patent Office

Office européen des brevets

**(11)** **EP 0 751 403 A1**

**(12)** **EUROPEAN PATENT APPLICATION**

**(43)** Date of publication:
02.01.1997 Bulletin 1997/01

**(51)** Int. Cl.⁶: **G01V 3/08**

**(21)** Application number: 95110238.3

**(22)** Date of filing: 30.06.1995

**(84)** Designated Contracting States:
AT BE CH DE DK ES FR GB GR IE IT LI LU MC NL PT SE

**(71)** Applicant: **Carlo Gavazzi AG**
**CH-6312 Steinhausen (CH)**

**(72)** Inventor: **Brorsen, Hans,**
c/o **Carlo Gavazzi AG**
**CH-6312 Steinhausen (CH)**

**(74)** Representative: **Kehl, Günther, Dipl.-Phys. et al**
**Patentanwälte**
**Hagemann & Kehl**
**Postfach 86 03 29**
**81630 München (DE)**

**(54) Combined sensor**

**(57)** A combined sensor comprises a hybrid sensorhead 1 for sensing capacitive and / or inductive changes, and evaluation means 2 for processing the signal from the hybrid sensorhead 1. The respective operation mode of the combined sensor can either be controlled by manually operable selection means 3 or by automatically one-time-programmable (OTP) or reprogrammable control means 4.

The hybrid sensorhead 1 comprises an oscillator coil 10 forming a sensing means with the combined sensor working in the respective operation mode, together with an partially conductive core 11.

By combining a capacitive and an inductive principle, an intelligent electronic sensor capable of applying at least two different sensing principles in one housing is provided. This combination of different sensing principles guarantees a synergetic effect concerning a secure and reliable detection of more than only one different type of approaching object. Besides, costs and space, required by electronic devices containing such sensors, are reduced.

Fig.1

## Description

The present invention generally relates to the field of electronic sensors, switches, or transducers. In particular, the present invention relates to sensors using a capacitive or an inductive sensing principle for sensing capacitive or inductive changes.

Electronic sensors of the prior art are commonly implemented in electric control circuits or electric regulator circuits. Unlike mechanically manipulated electric sensors, they are realized in a non-contacting way. This is especially true for microwave sensors, optical sensors, temperature sensors, ultrasonic sensors, wind sensors and the like, which are often based on two or more sensing principles and which nowadays work without exception in a contactless manner.

Such sensors are for example used to detect whether an object for which the corresponding sensor is sensitive has approached this sensor and has entered the sensing range of this sensor. Then, it is activated by means indicating the presence of the object. In the case of an electronic sensor being implemented as a make contact, the non-conductive electronic switch now becomes conductive, in the case of an electronic sensor being implemented as a break contact, the conductive electronic switch now becomes nonconducting. Electronic sensors of this well-known type are also used to detect whether a physical quantity of a medium for which the electronic sensor is sensitive has reached a corresponding predetermined value.

Thus, the means indicating the presence of the object to be detected is an essential part of electronic switching devices such as described above. Such a means indicating the presence of the object is for example realized by an oscillator circuit which is capacitively or inductively controlled. Alternatively, a so-called optoelectronic sensor, for instance a photo resistor, a photo diode or a photo transistor can be used to detect the presence of the object.

Conventional capacitive sensors are implemented in such a manner that a sensing capacitance is connected in series to an oscillator circuit. The operation of this oscillator circuit can be described by the product $f \cdot A$, where $f$ is the feedback factor and $A$ is the loop gain factor. As long as a certain object approaching a capacitive sensing plate has not sufficiently changed the capacity of the capacitive sensor, the relation $f \cdot A < 1$ remains valid for the oscillator circuit, i. e. the distance of the object from the capacitive sensor is still too large so as to trigger an oscillation. With the object reaching a predetermined distance from the capacitive sensor the changing capacitance between the object and the capacitive sensing plate results in an augmentation of the feedback factor $f$ (with the loop gain factor $A$ being constant). With the sensing capacitance being charged beyond a corresponding threshold and, consequently, the product $f \cdot A$ reaching the value 1, the oscillator circuit starts operating on the edge of the oscillation. The amplitude level of the oscillation is detected and used as an ON / OFF signal.

Conventional inductive sensors are implemented in an analogous manner. The basis of the inductive sensor principle is a high frequency- (HF-) oscillator, which can be influenced from the outside by metal objects. The sensing element is the oscillator coil of a LC-resonance circuit generating an electromagnetic field which passes the active face.

A sensing coil is connected in series to an oscillator circuit which is inductively controlled by the sensing coil. The operation of this oscillator circuit can also be described by the product $f \cdot A$, where $f$ is the feedback factor and $A$ is the loop gain factor. As long as a certain object approaching the coil of the inductive sensor has not come sufficiently close to the inductive sensor and has not sufficiently changed the quality of the inductivity of the inductive sensor, losses of eddy currents occur and the relation $f \cdot A > 1$ is valid for the oscillator circuit, i. e. the distance of the object from the inductive sensor is large enough to keep the oscillator in oscillating condition. With the object reaching a predetermined sensing distance from the inductive sensor, eddy currents occur producing a decrease of the quality (or loop gain factor A) of the oscillator circuit. This decrease of the loop gain factor A (with the feedback factor f being constant) because of the increasing attenuation of the oscillator results in the product $f \cdot A$ becoming smaller than 1, i. e. the oscillation amplitude is reduced until the oscillation stops. This status of the vanishing oscillation is detected by the signal processing circuit, which is electrically connected to said resonance circuit, and the above-mentioned switching signal for making or breaking a contact is derived from that.

In general, the applicability of electronic sensors according to the prior art has left much to be desired because these electronic sensors have been constricted to one sole sensing principle. Therefore, it has often been not possible to cover a broader range of possible sensor applications or to choose the best, safest and most efficient sensing principle for the specific object to be detected. As a consequence, many different sensors had to be stocked resulting in high costs.

In consideration of these problems, it is an object of the present invention to provide an intelligent electronic sensor capable of applying at least two different sensing principles in one housing. This combination of different sensing principles in one housing would guarantee a synergetic effect concerning a secure and reliable detection of more than only one different type of approaching object. Besides, costs and space, required by electronic devices containing such sensors, could be reduced because of the fewer number of different types and the more compact embodiment which is also important for the object of miniaturizing such electronic devices.

These objects are achieved by a combined sensor comprising a hybrid sensorhead combining a capacitive and an inductive principle for sensing capacitive and / or inductive changes, and evaluation means for processing the signal from the hybrid sensorhead.

The combined sensor preferably works either in the capacitive or in the inductive operation mode. In an especially advantageous embodiment of the present invention, selection means are provided in order to control the operation mode.

The operation mode can be selected manually, for example by a mechanical, electromechanical or electrical switch, and it can be controlled in the same way. Provided, that it is not a sensor with a fixed distance, the sensing distance can be adjusted after having manually selected the operation mode.

Alternatively, the selection means can be operated automatically by one-time-programmable (OTP) or by reprogrammable control means. After having mounted or placed the sensor in the appropriate distance from the target, the combined sensor is put into programming mode by activating a switch, connecting a wire or the like. Since the capacitive mode is basically not as safe as the inductive mode, the combined sensor will start in the latter mode which is selected and stored electrically with the sensor being ready for use. In case, the sensor cannot be activated in the inductive mode, the capacitive mode will be tried and stored if the target has activated the combined sensor. Alternatively, the combined sensor will start up in the inductive mode and electrically adjust the sensing distance according to the distance of the target. If it is possible to adjust the combined sensor within some safety limits, the selected mode as well as the detecting distance are stored electrically with the sensor being ready for use. In case, a reprogramming of the sensor is required, the stored information is erased by pushing a switch, connecting or disconnecting a wire, changing a polarity or the like. Afterwards, the reprogramming process can be started.

In order to enable an automatic selection of the operation mode, the one-time-programmable (OTP) or the reprogrammable control means comprise adjusting means for adjusting the operation mode, a programming unit with a memory unit, a control unit for controlling the programming, and an external communication port. The programming unit can advantageously be connected to the selection means, to the adjusting means, to the memory unit, and to the control unit, and the external communication port can preferably be connected to the control unit.

According to an especially advantageous embodiment of the present invention, the hybrid sensorhead comprises an oscillator coil forming a capacitive sensing means with the combined sensor working in the capacitive operation mode and forming an inductive sensing means with the combined sensor working in the inductive operation mode, together with a partially conductive core of a material with high magnetic permeability, preferably ferrite. By combining the two sensing principles in one embodiment, the sensor can be operated either in the capacitive or in the inductive operation mode without the necessity of providing two different sensors. By this way, the respective advantages of the two sensing principles are combined.

In a preferred embodiment of the present invention, the oscillator coil can be at least partially embedded in the core in order to bundle the lines of the magnetic flux produced by the coil. The higher the convergence of these magnetic flux lines is, the more sensitive the combined sensor is to inductive changes created by the approach of a target to be detected. Besides, at least the surface of the core preferably forms a shielding means for the capacitive sensing means against influences from material which is placed directly behind the hybrid sensorhead.

According to a preferred embodiment of the present invention, the sides and / or the rear of the core are at least partially coated with conductive material to get a higher conductivity of the surface. Since the surface of the core works as a shielding means backwards of the capacitive sensing means, the shielding effectivity to capacitive interferences is substantially increased by conductive material, such as conductive lacquer or a metallic foil.

It also lies within the scope of the invention to provide a combined sensor, wherein an additional capacitive sensing plate is arranged in front of the core so as to increase the sensitivity of the capacitive sensing means. This principle uses the fact, that some metals like stainless steel, copper, brass or aluminium only create little eddy currents if the oscillation frequency of the alternating electromagnetic field is low and the thickness of the metal is small, i. e. metals can be detected through metals. When a target enters the area in front of the capacitive sensing means, the dielectric constant is changed. By providing a capacitive sensing plate, these changes of the dielectric constant are detected in a more secure way thus resulting in more reliable results concerning the presence and the distance of an object.

Since the electrical field spreads out in all directions, the hybrid sensorhead would be sensitive to all directions. Thus, additional shielding means advantageously arranged at the rear of the core is provided to protect the core with its conductive surface from capacitive changes caused by interferential action from material directly behind the hybrid sensorhead, and it prevents the capacitive coupling which takes place laterally of the core. Consequently, sensitivity just in the desired direction is warranted, and all capacitive changes due to electromagnetic interference as for instance electrostatic distortion affect only this shielding means which are consequently intended to guarantee a shielding of the sensitive parts of the device without a gap. An additional isolation between the core and the shielding means can be preferably arranged in order to ensure a reliable and exact function of the shielding means.

According to a particularly advantageous embodiment of the invention, the hybrid sensorhead comprises a compensation electrode. By adding such a compensation electrode with a signal in phase with the signal on the sensing electrode, it is possible to minimize the capacitive coupling from the sensing electrode directly back to the electronics on for example a PCB (printed circuit board) by adjusting the amplitude on the compensation electrode. By this means, a coupling between equivalent signals is avoided.

Preferably, the shielding means and the compensation electrode are connected together though they have different functions. While the former is provided to shield against the oscillator coil and the core with its conductive surface and highly dielectric materials, the latter is intended to compensate the interferential influences from the material the sensing electrode is mounted on (for example a PCB (printed circuit board)). Since the shielding means preferably carries the same potential as the compensation electrode and as the sensor electrode, the shielding means does not have any capacitive influence on the sensor electrode under normal operating conditions. Generally, the shielding means present an effective way of reducing the sensitivity of the sensor electrode with respect to the influence from electronics and moulding material inside the combined sensor.

In a preferred embodiment of the present invention, protective means, preferably provided by a conductive tube of arbitrary length and shape arranged around the PCB (printed circuit board) carrying the electronics, is connected to the shielding means and the compensation electrode. By connecting this conductive tube with the shielding means and the compensation electrode, the capacitive influence of such protective means is canceled out and no capacitive load is imposed on the capacitive sensing means. Thus, such protective means can be used as a protection against electromagnetic interference as for instance electrostatic distortion.

In a particularly advantageous embodiment of the present invention, the combined sensor comprises evaluation means for measuring the frequency variation of the signal $f_{out}$ of the oscillator means. This evaluation means preferably comprises detection means for receiving the signal coming from the hybrid sensorhead, integration means which level out small erroneous variations of the period time $T_{out} = 1 / f_{out}$ due to transients, threshold means, and output means for processing the signal.

According to a further embodiment of the present invention, the detection means comprises detection means for the capacitive signal and detection means for the inductive signal which renders an advantageous possibility of receiving the respective signals independently. In an analogous way, the integration means comprises integration means for the capacitive signal and integration means for the inductive signal for independently process the signal coming from the respective detection means.

Where it is not possible to guarantee a tight, stable and secure connection between the hybrid sensorhead and the evaluation means for instance by attaching at least one of the wires connecting the hybrid sensorhead to the evaluation means by soldering in form of a solder point, said wire can also be attached to the hybrid sensorhead by conductive glue.

The present invention will be described in more detail below with reference to the exemplary embodiments which are schematically illustrated in the following drawings, in which:

Fig. 1 is a circuit diagram showing an example of a combined sensor in accordance with the invention;

Fig. 2 is a circuit diagram showing an example of a manually controllable combined sensor in accordance with the invention;

Fig. 3 is a circuit diagram showing an example of an automatically controllable combined sensor in accordance with the invention;

Fig. 4 is a circuit diagram showing an embodiment of a detection means for a capacitive signal;

Fig. 5 is a circuit diagram showing a first embodiment of a detection means for an inductive signal;

Fig. 6 is a circuit diagram showing a second embodiment of a detection means for an inductive signal;

Fig. 7 is a plan view of a hybrid sensorhead according to a first embodiment of the invention;

Fig. 8 is a sectional view of a hybrid sensorhead according to a first embodiment of the invention;

Fig. 9 is a plan view of a hybrid sensorhead according to a second embodiment of the invention;

Fig. 10 is a sectional view of a hybrid sensorhead according to a second embodiment of the invention;

Fig. 11 is a plan view of a hybrid sensorhead according to a third embodiment of the invention;

Fig. 12 is a sectional view of a hybrid sensorhead according to a third embodiment of the invention;

Fig. 13 is a sectional view of a hybrid sensorhead according to a fourth embodiment of the invention;

Fig. 14 is a sectional view of a hybrid sensorhead according to a fifth embodiment of the invention;

Fig. 15 is a sectional view of a hybrid sensorhead according to a sixth embodiment of the invention;

Fig. 16 is a plan view of a hybrid sensorhead according to a seventh embodiment of the invention;

Fig. 17 is a sectional view of a hybrid sensorhead according to a seventh embodiment of the invention; and

Fig. 18 is a sectional view of a hybrid sensorhead according to an eighth embodiment of the invention.

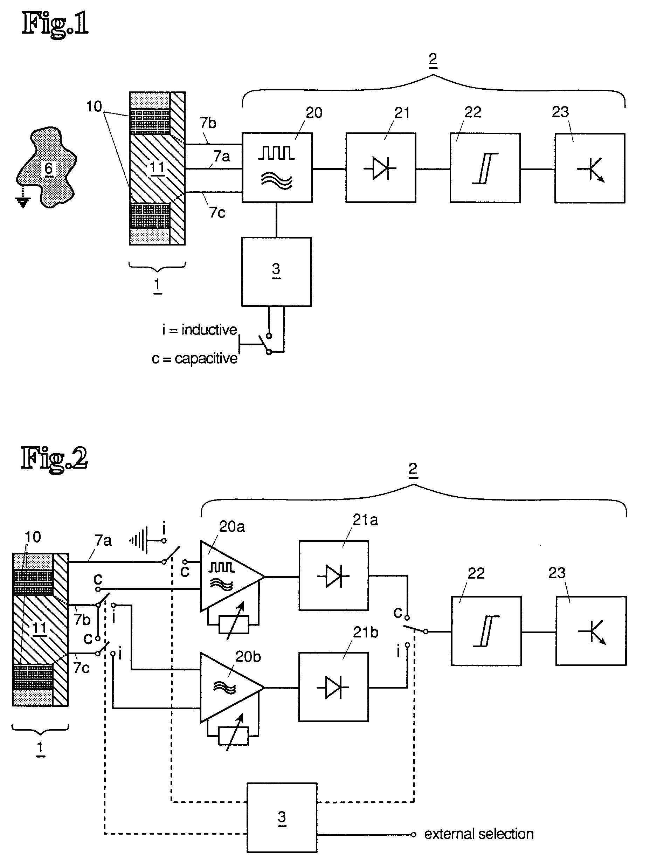

An example of realizing the combined sensor in accordance with the invention is illustrated in figure 1. This combined sensor can for example be implemented in an electric control circuit or in an electric regulator circuit in order to detect the presence of an object 6, for example a solid or a liquid of any shape and volume, placed at a variable distance in front of the combined sensor. This combined sensor can also be used to detect whether a physical quantity of a medium the combined sensor is sensitive for has reached a corresponding predetermined value. Needless to say, that the combined sensor can also be used to sense capacitive or inductive changes in many other applications as for instance relative humidity sensors or membrane cells for pressure measurements. The basic principle of this combined sensor which will be explained in more detail below is as follows: as the capacity or inductivity of the hybrid sensorhead 1 changes with the approaching object 6 or the quantity to be measured, the frequency of the output of this hybrid sensorhead 1 changes with it.

The embodiment of a combined sensor according to the invention shown in figure 1 basically consists of the hybrid sensorhead 1, which comprises an oscillator coil 10 as well as a partially conductive core 11 and which combines a capacitive and an inductive principle for sensing capacitive and / or inductive changes, evaluation means 2 connected in series to the hybrid sensorhead 1 via the wires 7a, 7b and 7c, and selection means 3 for controlling whether the combined sensor works in the capacitive or in the inductive operation mode.

The evaluation means 2 which are designated for receiving and processing the signal from the hybrid sensorhead 1 comprises detection means 20, integration means 21, threshold means 22, and output means 23. It can also be seen from figure 1 that the detection means 20 of the evaluation means 2 are connected in series to the selection means 3.

Figure 2 shows a view of a circuit diagram of a manually controllable combined sensor according to the invention. It should be noted that the selection means 3 permits a manual selection of the operation mode, i. e. it can be decided by the operator himself whether the combined sensor should work in the capacitive mode or in the inductive operation mode. The respective operation mode is selected and controlled for example via a mechanical, electromechanical or electrical switch connecting a wire to a specific polarity or specific connections of terminals. After having selected a specific operation mode, the sensing distance can be subsequently adjusted by the operator, provided the sensing distance is not fixed.

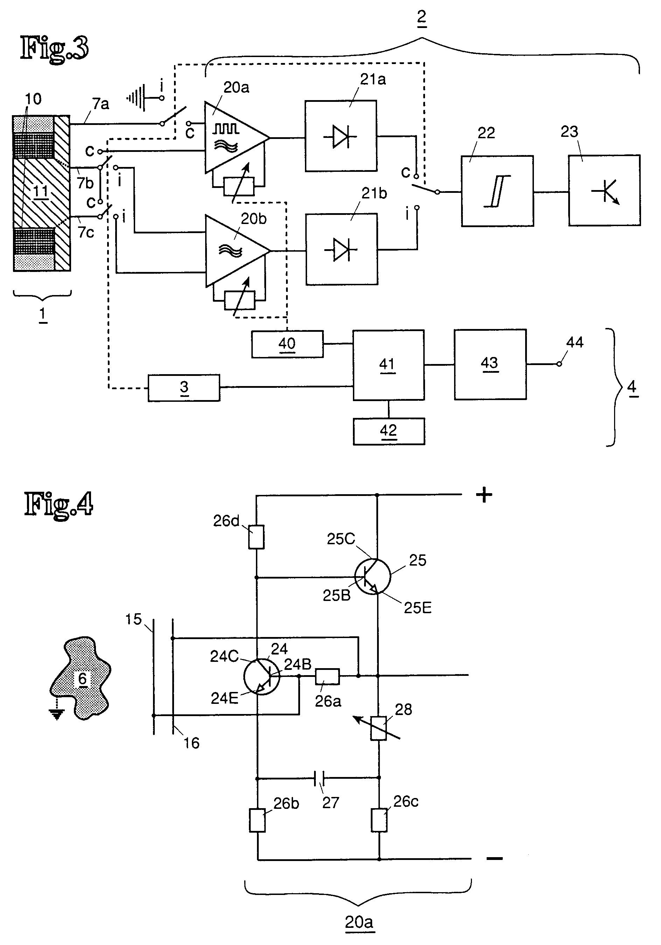

It can be seen from figure 2, that the detection means 20 comprises detection means 20a for the capacitive signal and detection means 20b for the inductive signal. By that means, a separate receiving of the signal coming from the hybrid sensorhead 1 according to the respective operation mode, in which the combined sensor works, is made possible. A detailed description of the respective detection means 20a and 20b will be given below (see figures 4, 5, and 6). In an analogous way, the integration means 21 comprises integration means 21a for the capacitive signal and integration means 21b for the inductive signal in order to separately process the signal coming the respective detection means 20a or 20b.

Unlike the embodiment of the combined sensor shown in figure 2, the selection means 3 can alternatively be controlled automatically by one-time-programmable (OTP) or by reprogrammable control means 4 which is illustrated in figure 3. The OTP or the reprogrammable control means 4 comprise adjusting means 40 for adjusting the operation mode, a programming unit 41 with a memory unit 42, a control unit 43 for controlling the programming, and an external communication port 44. The programming unit 41 is connected to the selection means 3, to the adjusting means 40, to the memory unit 42 as well as to the control unit 43, and the latter is connected to the external communication port 44.

When the operation mode is determined automatically, the combined sensor is placed or mounted in an appropriate distance from the object 6 to be detected (not shown in figure 3). Then, the programming unit 41 is put into programming mode via the control unit 43, for example by activating a switch, connecting a wire or connecting a power supply. The combined sensor will start up in the inductive operation mode because the results of the inductive operation mode are generally more reliable than the results of the capacitive operation mode. Thus, with the combined sensor being activated, the inductive operation mode is selected and stored in the memory unit 42, and the combined sensor is ready for detecting the object 6. If the combined sensor cannot be activated in the inductive operation mode, the capacitive operation mode will be tried by the control unit 43 and stored in the memory unit 42, if the object 6 has activated the combined sensor.

In adjusting mode, the object 6 is placed in the right distance from the hybrid sensorhead 1, the sensing distance is adapted by the adjusting means 40 connected to the programming unit 41. Again, the combined sensor will start up in the inductive operation mode. If it is possible to adjust the combined sensor within certain safety limits, the selected operation mode and the detecting distance are stored electrically in the memory unit 42, and the combined sensor is ready for use. Again, capacitive operation mode will be tried with an analogous procedure as described above, if the combined sensor cannot be activated in the inductive operation mode.

Another important feature of the embodiment of the combined sensor shown in figure 3 is the possibility to reprogram it. In case, a reprogramming of the combined sensor should be necessary, the information which is stored in the memory unit 42 of the reprogrammable control means 4 is erased for example by pushing a switch, connecting or disconnecting a wire or changing the polarity for a certain time. After that, a programming of the combined sensor can be started, as it has been described above.

It has already been said, that detection means 20a can be provided for detecting the capacitive signal. An exemplary circuit diagram of such a detection means 20a is shown in figure 4, wherein reference numeral 15 designates a capacitive sensing plate for sensing capacitive changes due to the presence or approach of the object 6 to be detected. Said capacitive sensing plate 15 is connected to the base 24B of an input npn-transistor 24. The voltage at the collector 24C of this input npn-transistor 24 is fed to the base 25B of a second npn-transistor 25, the emitter 25E of which is connected to a shielding means 16 as well as to the base 24B of the input npn-transistor 24 (via a resistor 26a). Furthermore, the detection means 20a for detecting the capacitive signal comprises a second resistor 26b in parallel to which a capacitor 27 as well as another resistor 26c are placed. The latter circuit elements are connected to the emitter 24E of the input npn-transistor 24. It can also be seen from figure 4, that a controllable resistor 28 is connected to the capacitor 27 and the resistor 26c as well as to the emitter 25E of the second npn-transistor 25 in order to adjust the level of the detection means 20a. Said detection means 20a of figure 4 which is formed as a RC oscillator with negative feedback, i. e. the external influence is placed in the negative feedback loop, works at the edge of the oscillation under normal operating conditions. Of course, other principles for sensing capacitive changes which are not shown in figure 4 can be used.

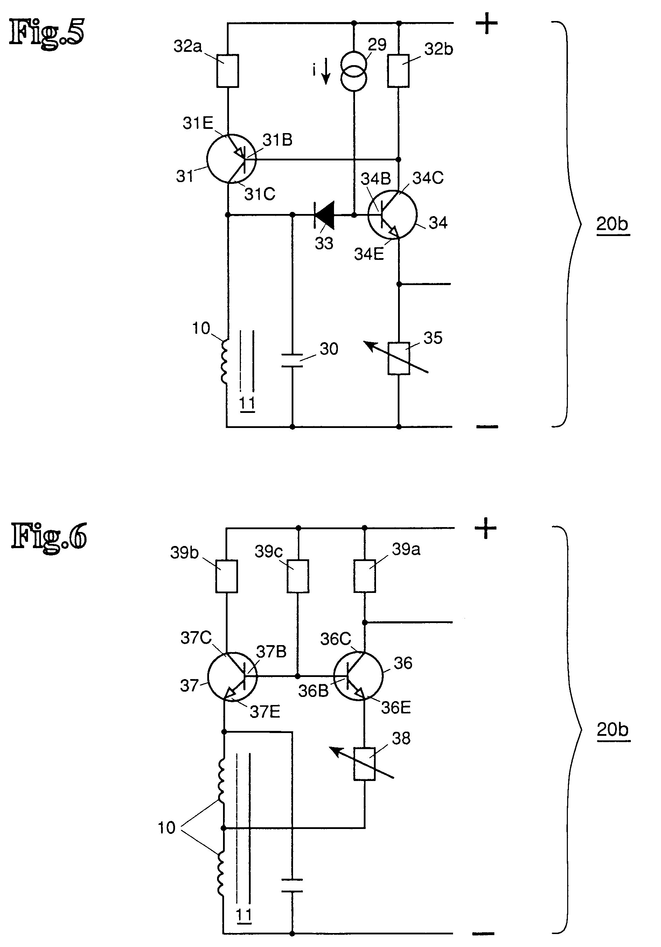

Figure 5 is a circuit diagram showing a first embodiment of a detection means 20b for detecting an inductive signal, a so called inductive detection circuit based on the Meißner principle. A Meißner oscillator is characterized in that the input and the output current have to be in phase in order to obtain an oscillation. The necessary feedback results from an oscillator controlled constant current generator which charges the LC resonance circuit. The output signal is equal to the amplitude of the LC resonance circuit.

In a more detailed description of figure 5, the positive feedback results from the oscillator coil 10 the windings of which determine together with a capacitor 30 the frequency $f = (2\pi)^{-1} (LC)^{-0.5}$ of the resonance oscillation, where L designates the inductivity of the oscillator coil 10 and C designates the capacity of the capacitor 30. The oscillator coil 10 with its core 11 is placed in parallel to said capacitor 30, and the latter circuit elements are connected to the collector 31C of a pnp-transistor 31 the emitter 31E of which is connected to a current generator 29 via a resistor 32a. Said current generator 29 is also connected to the input of a diode 33 as well as to the base 34B of a npn-transistor 34 the emitter 34E of which is connected to the LC resonance element 10, 30 via a controllable resistor 35, and the collector 34C of said npn-transistor 34 is connected to the base 31B of the pnp-transistor 31 as well as to the positive supply voltage via a resistor 32b.

Figure 6 shows a circuit diagram showing a second embodiment of a detection means 20b for detecting an inductive signal, a so called inductive detection circuit based on the Hartley principle. Unlike the Meißner oscillator, a Hartley oscillator is characterized in that the positive feedback results from a tapped coil 10 which is connected to the emitter 36E of a npn-transistor 36 via a controllable resistor 38 as well as to the emitter 37E of another npn-transistor 37. The respective bases 36B and 37B of this pair of npn-transistors 36 and 37 are connected together, and the collectors 36C and 37C are connected to respective resistors 39a and 39b, in parallel to which a third resistor 39c is placed which is connected to the bases 36B and 37B of the npn-transistors 36 and 37.

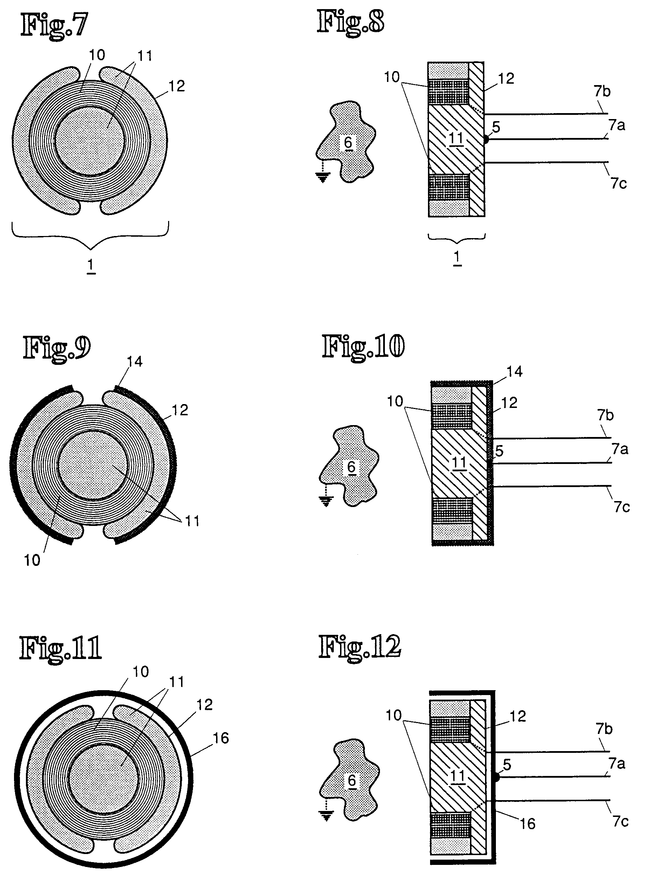

Figure 7 shows a first embodiment of a hybrid sensorhead 1 according to the invention. In the plan view of figure 7, reference numeral 10 designates an oscillator coil forming a capacitive sensing means with the combined sensor working in the capacitive operation mode and forming an inductive sensing means with the combined sensor working in the inductive operation mode, thus consisting of several windings which can be printed on a PCB (printed circuit board) having the shape of a ring (not shown in figure 7). The oscillator coil 10 which also forms a sensor electrode is at least partially embedded in a partially conductive core 11 of a material with high magnetic permeability, e. g. ferrite, such as it is commonly used in high frequency oscillator coils. It should be mentioned, that at least the surface of this core 11 forms a shielding means 12 for the capacitive sensing means against influences from material directly behind the hybrid sensorhead 1.

In order to realize a combined sensor principle, the oscillator coil 10 forms a capacitive sensing means with the combined sensor working in the capacitive operation mode, and it forms an inductive sensing means with the combined sensor working in the inductive operation mode. By combining the two sensing principles in one embodiment, the sensor can be operated either in the capacitive or in the inductive operation mode without the necessity of providing two different sensors. By this way, the respective advantages of the two sensing principles are combined without the necessity of providing two different sensors.

The oscillator coil 10 and the core 11 the surface of which forms the shielding means 12 are also shown in the sectional view of figure 8. Besides, this figure reveals that the wire 7a connecting the shielding means 12 of the hybrid sensorhead 1 to the evaluation means

2 is attached to the shielding means 12 by a solder point or, where the latter is not possible, by conductive glue 5. The connection between the oscillator coil 10 and the evaluation means 2 is provided by wires 7b and 7c. The exact wiring between the shielding means 12 as well as the oscillator coil 10 of the hybrid sensorhead 1 and the detection means 20a for the capacitive signal as well as the detection means 20b for the inductive signal can be seen from the figures 2 and 3 described above.

In order to get a higher conductivity of the surface of the core 11, the sides and / or the rear of the core 11 can at least partially be coated with conductive material 14, as it is shown in the figures 9 (plan view) and 10 (sectional view). Since the surface of the core 11 works as a shielding means 12 backwards of the capacitive sensing means, the shielding effectivity to capacitive interferences is substantially increased by conductive material 14, such as conductive lacquer or a metallic foil.

With the electrical field spreading out in all directions, the hybrid sensorhead 1 would be sensitive to all directions. Thus, the figures 11 (plan view) and 12 (sectional view) show a third embodiment of the present invention comprising additional shielding means 16 arranged laterally to and at the rear of the core 11. This shielding means 16 is provided to protect the hybrid sensorhead 1 with its conductive surface from capacitive changes caused by interferential action from material directly behind the hybrid sensorhead 1, and it prevents capacitive coupling.

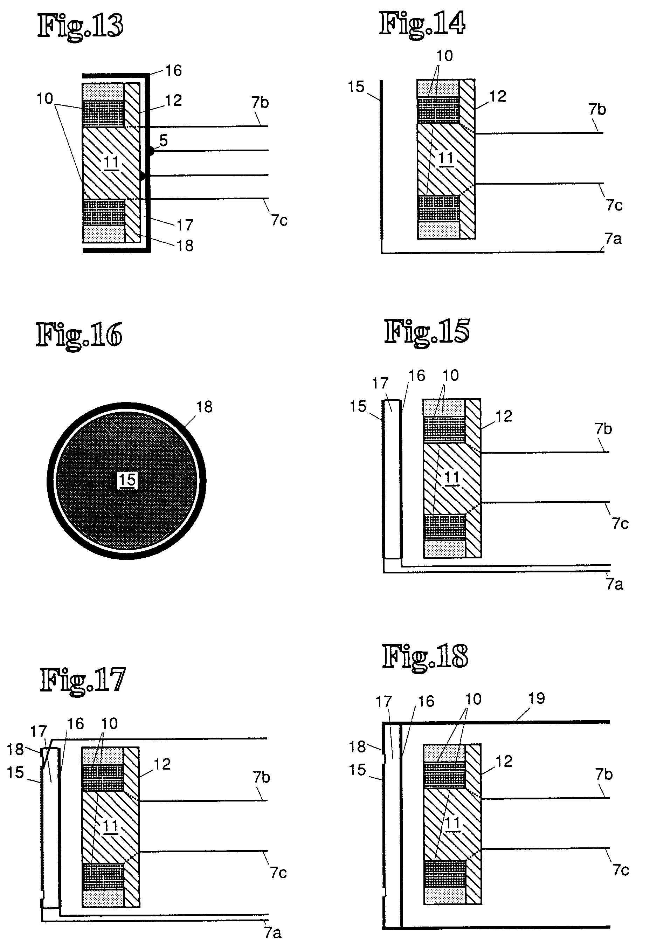

Figure 13 is a sectional view of a hybrid sensorhead 1 according to a fourth embodiment of the invention, wherein the core 11 is used as a compensation electrode 18. By adding such a compensation electrode 18 with a signal in phase with the signal on the sensing electrode, it is possible to minimize the capacitive coupling from the sensing electrode directly back to the electronics of the evaluation means 2 by adjusting the amplitude on the compensation electrode 18. By this means, undesired coupling between equivalent signals is avoided. Additionally, an isolation 17 between the core 11 and the shielding means 16 is arranged in order to ensure a reliable function of said shielding means 16.

A fifth embodiment of the present invention which is illustrated in the sectional view of figure 14, comprises an additional sensing electrode, formed as a capacitive sensing plate 15 arranged in front of the core 11 so as to increase the sensitivity of the capacitive sensing means. This principle uses the fact, that some metals like stainless steel, copper, brass or aluminium only create little eddy currents if the oscillation frequency of the alternating electromagnetic field is low and the thickness of the metal is small, i. e. metals can be detected through metals. When the object 6 enters the area in front of the hybrid sensorhead 1, the dielectric constant is changed. By providing a sensing electrode in form of a capacitive sensing plate 15, these changes of the dielectric constant are detected in a more secure way thus resulting in more reliable results concerning the presence and the distance of the object 6 to be detected.

Additionally, shielding means 16 which are connected to the sensing electrode 15 can be arranged, as it is shown in the sectional view of a hybrid sensorhead 1 according to a sixth embodiment of the present invention (figure 15). Again, an isolation 17 between the capacitive sensing plate 15 and the shielding means 16 is provided.

The figures 16 (plan view) and 17 (sectional view) show a seventh embodiment of the present invention, wherein a compensation electrode 18 surrounding the sensing electrode 15 is provided. By adding such a compensation electrode 18 with a signal in phase with the signal on the sensing electrode 15, it is possible to minimize the capacitive coupling from the sensing electrode 15 directly back to the electronics of the evaluation means 2 by adjusting the amplitude on the compensation electrode 18. By this means, undesired coupling between equivalent signals is avoided.

In the figures 16 and 17, the shielding means 16 and the compensation electrode 18 are connected together though they have different functions. While the former is provided to shield against the oscillator coil 10 and the core 11 with its conductive surface and highly dielectric materials, the latter is intended to compensate the interferential influences from the material the sensing electrode 15 is mounted on. Since the shielding means 16 carries the same potential as the compensation electrode 18 and as the sensor electrode 15, the shielding means 16 does not have any capacitive influence on the sensor electrode 15 under normal operating conditions. Generally, the shielding means 16 present an effective way of reducing the sensitivity of the sensor electrode 15 with respect to the influence from electronics and moulding material inside the combined sensor.

Figure 18 shows a sectional view of a hybrid sensorhead 1 according to an eighth embodiment of the present invention and illustrates the provision of protective means 19 connected to the shielding means 16 as well as to the compensation electrode 18. This protective means is provided by a conductive tube 19 arranged around the hybrid sensorhead 1 and the wires 7 connecting said hybrid sensorhead 1 to the evaluation means 2. By connecting this conductive tube 19 to the shielding means 16 and to the compensation electrode 18, the capacitive influence of such protective means 19 is cancelled out and no capacitive load is imposed on the shielding means 12. Thus, such protective means 19 can be used as a protection against electromagnetic interference as for instance electrostatic distortion.

**Claims**

1. A combined sensor comprising

   a) a hybrid sensorhead (1) combining a capacitive and an inductive principle for sensing capacitive and / or inductive changes, and

b) evaluation means (2) for processing the signal from the hybrid sensorhead (1).

2. A combined sensor according to claim 1, wherein the combined sensor works either in the capacitive or in the inductive operation mode, the operation mode being controlled by selection means (3).

3. A combined sensor according to claim 2, wherein the selection means (3) can be operated manually.

4. A combined sensor according to claim 2, wherein the selection means (3) can be controlled automatically by one-time-programmable (OTP) or by reprogrammable control means (4).

5. A combined sensor according to claim 4, wherein the one-time-programmable (OTP) or the reprogrammable control means (4) comprise adjusting means (40) for adjusting the operation mode, a programming unit (41) with a memory unit (42), a control unit (43) for controlling the programming, and an external communication port (44).

6. A combined sensor according to claim 5, wherein the programming unit (41) is connected to the selection means (3), to the adjusting means (40), to the memory unit (42), and to the control unit (43).

7. A combined sensor according to claim 5 or 6, wherein the external communication port (44) is connected to the control unit (43).

8. A combined sensor according to any of the claims 2 to 7, wherein the hybrid sensorhead (1) comprises

    a) an oscillator coil (10) forming a capacitive sensing means with the combined sensor working in the capacitive operation mode and forming an inductive sensing means with the combined sensor working in the inductive operation mode,
    b) together with a partially conductive core (11) of a material with high magnetic permeability.

9. A combined sensor according to claim 8, wherein the material, of which the core (11) is made, is ferrite.

10. A combined sensor according to claim 8 or 9, wherein the oscillator coil (10) is at least partially embedded in the core (11).

11. A combined sensor according to any of the claims 8 to 10, wherein at least the surface of the core (11) forms a shielding means (12) for the capacitive sensing means.

12. A combined sensor according to any of the claims 8 to 11, wherein the sides and / or the rear of the core (11) are at least partially coated with conductive material (14), such as conductive lacquer or a metallic foil.

13. A combined sensor according to any of the claims 8 to 12, wherein a capacitive sensing plate (15) is arranged in front of the core (11).

14. A combined sensor according to any of the claims 8 to 13, wherein the hybrid sensorhead (1) comprises shielding means (16) arranged around the core (11).

15. A combined sensor according to claim 14, wherein an isolation (17) is arranged between the core (11) and the shielding means (16).

16. A combined sensor according to any of the claims 1 to 15, wherein the hybrid sensorhead (1) comprises a compensation electrode (18).

17. A combined sensor according to claim 15 and 16, wherein the shielding means (16) and the compensation electrode (18) are connected together.

18. A combined sensor according to claim 15 and 16 or to claim 17, wherein protective means (19) is connected to the shielding means (16) and the compensation electrode (18).

19. A combined sensor according to claim 18, wherein the protective means is provided by a conductive tube (19) of arbitrary length and shape.

20. A combined sensor according to any of the claims 1 to 19, wherein the evaluation means (2) comprises detection means (20), integration means (21), threshold means (22), and output means (23) for receiving and processing a signal from the hybrid sensorhead (1).

21. A combined sensor according to claim 20, wherein the detection means (20) comprises detection means (20a) for the capacitive signal and detection means (20b) for the inductive signal.

22. A combined sensor according to claim 20 or 21, wherein the integration means (21) comprises integration means (21a) for the capacitive signal and integration means (21b) for the inductive signal.

23. A combined sensor according to any of the claims 1 to 22, wherein at least one of the wires (7) connecting the hybrid sensorhead (1) to the evaluation means (2) is attached to the hybrid sensorhead (1) by a solder point or by conductive glue (5).

## Fig.1

i = inductive
c = capacitive

## Fig.2

external selection

**Fig.3**

**Fig.4**

**Fig.5**

**Fig.6**

Fig.7

Fig.8

Fig.9

Fig.10

Fig.11

Fig.12

Fig.13

Fig.14

Fig.16

Fig.15

Fig.17

Fig.18

EP 0 751 403 A1

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X<br>A | DE-A-32 35 535 (NOLTA GMBH) 29 March 1984<br>* page 6, line 14 - page 7, line 3 *<br>* figures 3-5 *<br>* page 7, line 20 - line 24 *<br>--- | 1-3,8,9<br>20-23 | G01V3/08 |
| X<br><br>A | WO-A-87 00933 (CONS TECHNOLOGY PTY LTD) 12<br>February 1987<br>* page 1, line 1 - page 2, line 10 *<br>* page 4, line 18 - line 22 *<br>* figure 1 *<br>--- | 1-3<br><br>20-23 | |
| X | DE-A-25 38 531 (SIEMENS AG) 10 March 1977<br>* page 1, line 1 - page 2, line 12 *<br>* page 3, line 21 - page 4, line 6 *<br>* figures 1-5 *<br>--- | 1 | |
| X<br>A | US-A-3 764 819 (MULLER H) 9 October 1973<br>* column 2, line 53 - line 59 *<br><br>* column 6, line 43 - line 46 *<br>* figures 1-6 *<br>--- | 1<br>8-11,13,<br>20-23 | |
| X<br><br>A | GB-A-2 188 432 (DURACELL INT) 30 September<br>1987<br>* page 1, line 30 - line 61 *<br>* page 2, line 103 - line 121 *<br>* page 3, line 40 - line 46 *<br>----- | 1<br><br>11,20-23 | TECHNICAL FIELDS<br>SEARCHED (Int.Cl.6)<br><br>G01V<br>H03K |

The present search report has been drawn up for all claims

| Place of search | Date of completion of the search | Examiner |
|---|---|---|
| THE HAGUE | 10 November 1995 | D/L PINTA BALLE.., L |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
........................................................................
& : member of the same patent family, corresponding
   document

EPO FORM 1503 03.82 (P04C01)